# EUROPÄISCHE PATENTSCHRIFT

(11) **EP 0 850 481 B1**
(45) Veröffentlichungstag und Bekanntmachung des Hinweises auf die Patenterteilung: **27.10.1999**
(21) Anmeldenummer: 96931750.2
(22) Anmeldetag: 13.08.1996
(51) Int. Cl.: G11C 8/04

(54) **EINRICHTUNG ZUM SPRUNGWEISEN ADRESSIEREN BESTIMMTER LEITUNGEN EINES SERIELL ARBEITENDEN DIGITALEN SPEICHERS**
DEVICE FOR SKIP ADDRESSING CERTAIN LINES IN A SERIALLY OPERATING DIGITAL STORE
DISPOSITIF PERMETTANT D'ADRESSER PAR SAUT DES LIGNES DETERMINEES D'UNE MEMOIRE NUMERIQUE A FONCTIONNEMENT SEQUENTIEL

(30) Priorität: 13.09.1995 DE 19533953
(43) Veröffentlichungstag der Anmeldung: 01.07.1998
(73) Patentinhaber: SIEMENS AKTIENGESELLSCHAFT, 80333 München (DE)
(72) Erfinder: BOLLU, Michael, D-81671 München (DE); VON BASSE, Paul-Werner, D-82515 Wolfratshausen (DE); THEWES, Roland, D-82194 Gröbenzell (DE); SCHMITT-LANDSIEDEL, Doris, D-85521 Ottobrunn (DE)
(86) Internationale Anmeldenummer: DE9601511
(87) Internationale Veröffentlichungsnummer: WO9710600

(56) Entgegenhaltungen:
- EP-A- 0 305 583
- US-A- 5 444 660
- PATENT ABSTRACTS OF JAPAN vol. 7, no. 266 (P-239), 26.November 1983 & JP,A,58 146080 (KOGA TAKATOSHI)

## Beschreibung

Die Erfindung betrifft eine Einrichtung zum sprungweisen Adressieren bestimmter Leitungen eines seriell arbeitenden digitalen Speichers.

Seriell arbeitende Speicher bestehen aus einer aus matrixförmig in Zeilen und Spalten angeordneten Speicherzellen bestehenden Speichermatrix und aus Dekodierern oder anderen Steuereinrichtungen, beispielsweise Steuerketten (siehe beispielsweise ältere deutsche Patentanmeldung P 195 12 791.9 (= GR 95 P 1289), die auch Pointer genannt werden.

Die Speichermatrix enthält neben den Speicherzellen Bitleitungen und senkrecht zu diesen verlaufende Wortleitungen. Jede Speicherzelle ist mit einer Bitleitung verbunden und wird von einer Wortleitung angesteuert.

Wird eine Wortleitung von einem Wort-Dekodierer oder beispielsweise einer Wort-Steuerkette adressiert, d. h. ausgewählt, so liefern die Speicherzellen an dieser Wortleitung ihre Information an die ihnen zugeordneten Bitleitungen. Über einen Bit-Dekodierer oder beispielsweise eine Bit-Steuerkette wird anschließend eine der Bitleitungen und damit die Information einer bestimmten Speicherzelle adressiert, d.h. ausgewählt.

Bei sequentiell arbeitenden Speichern geschieht dieser Vorgang kontinuierlich, so daß nacheinander alle Speicherzellen angesprochen werden. Um aber eine möglichst korrigierbare Information (redundante Kodes) aus dem Speicher zu erhalten, dürfen die Zellen einer Wortleitung bzw. Bitleitung nicht direkt hintereinander ausgelesen werden. Bei komplett fehlerhaften Bit- bzw. Wortleitungen könnte der Informationsinhalt der Speicherzelle in diesem Falle nicht mehr korrigiert werden. Sehr häufig kommen aber auch Ausfälle von benachbarten Wort- und Bitleitungen vor. Es ist daher günstig, die Bit- bzw. Wort-Dekodierer oder -Steuerketten so anzuordnen, daß sie bei einem Wechsel der Auswahlleitungen niemals die direkten Nachbarleitungen ansteuern. Ein solches Verfahren wird hier als insbesondere sequentielle sprungweise Adressierung bezeichnet.

Mit den üblichen Binärdekodierern kann diese sprungweise Adressierung auf mehrere Arten gelöst werden:
1) Beispielsweise wird die den Dekodierern zugeführte Binäradresse nicht kontinuierlich erhöht, sondern in regelmäßigen Sprüngen.
2) Die Dekodierer sind so aufgebaut, daß bei kontinuierlicher Erhöhung der einem Dekodierer zugeführten Binäradresse Ausgänge des Dekodierers in regelmäßigen Abständen übersprungen werden.
3) Die Binäradresse wird in eine Sprungadresse und Auswahladresse geteilt. Eine solche Adressenteilung läßt infolge der Binäradressen nur Gruppengrößen zu, die ein ganzzahliger Teil aller auszuwählenden Leitungen sind, sonst werden nicht alle Leitungen ausgewählt oder einige Adressen wählen keine Leitungen aus, so daß sog. Leeradressen entstehen. Sollen Sprünge erreicht werden, die ein ganzzahliger Teil aller auszuwählenden Leitungen sind, so muß die Binäradresse in diesen Sprüngen erhöht werden. Diese Bedingung wird für seriell betriebene Speicher gefordert (siehe obengenanntes Dokument P 195 12 791.9).

Durch die im Anspruch 1 angegebene Einrichtung zum sprungweisen Adressieren bestimmter Leitungen eines seriell arbeitenden digitalen Speichers lassen sich vorteilhafterweise beliebige Sprungweiten realisieren.

Bei der erfindungsgemäßen Einrichtung sind den sprungweise zu adressierenden bestimmten Leitungen erfindungsgemäß zwei Steuereinrichtungen zugeordnet. Die bestimmten Leitungen können beispielsweise die Bitleitungen oder auch die Wortleitungen des Speichers oder beides sein.

Jede dieser Steuereinrichtungen ist so ausgebildet, daß sie mehrere Ausgänge aufweist und an diesen Ausgängen zeitlich nacheinander eine bestimmte, dieser Steuereinrichtung zugeordnete und für eine Adressierung einer bestimmten einzelnen Leitung maßgebende Binärinformation erzeugt.

Jede Steuereinrichtung kann beispielsweise durch eine Steuerkette realisiert sein.

Steuerketten arbeiten wie Schieberegister, die neben einer Binärinformation, beispielsweise der Information "0", nur einmal die andere Binärinformation, im angenommenen Beispiel die Information "1", enthalten. Diese andere Binärinformation erscheint an nur einem Ausgang der Steuerkette, während alle anderen Ausgänge dieser Steuerkette die eine Binärinformation aufweisen. Die andere Binärinformation kann mittels eines Taktes in einer vorbestimmten Richtung von Ausgang zu Ausgang der Steuerkette weitergeschoben werden.

Die Sprungweite, d. h. die Zahl der bestimmten Leitungen, die bei der Adressierung von einer zur nächsten bestimmten Leitung übersprungen wird, ist bei der erfindungsgemäßen Einrichtung durch die Zahl p der Ausgänge der einen Steuereinrichtung gemäß p - 1 bestimmt und frei wählbar, so daß sich beliebige Sprungweiten einstellen lassen. Vorzugsweise wird die Zahl p so gewählt, daß 1 ≤ p - 1 < N gilt. N ist die gesamte Zahl der bestimmten Leitungen.

Die Zahl q der Ausgänge der anderen Steuereinrichtung ist durch p und N bestimmt.

Die erfindungsgemäße Einrichtung wird erfindungsgemäß so betrieben, wie es im Anspruch 3 angegeben ist.

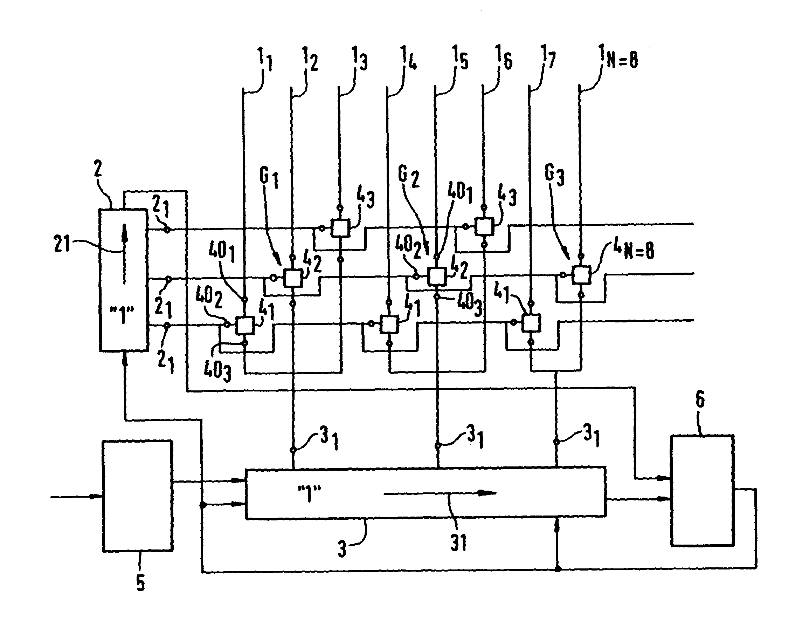

Die Erfindung wird in der nachfolgenden Beschreibung anhand der Figur beispielhaft näher erläutert.

Die Figur zeigt in schematischer Darstellung ein Schaltbild der erfindungsgemäßen Einrichtung, die für N = 8 Leitungen und eine Sprungweite p - 1 = 2, d. h. ein Überspringen von zwei Leitungen, ausgelegt ist.

In der Figur sind die N = 8 Leitungen des digitalen Speichers mit seriellem Betrieb mit 1₁ bis 1_{N = 8} bezeichnet. Der Speicher selbst ist nicht dargestellt. Die Leitungen 1₁ bis 1_{N} können Bitleitungen und/oder Wortleitungen dieses Speichers sein.

Die erfindungsgemäße Einrichtung zum sprungweisen Adressieren weist erfindungsgemäß zwei den bestimmten Leitungen 1₁ bis 1_{N} gemeinsam zugeordnete Steuereinrichtungen 2 und 3 auf, deren jede mehrere Ausgänge 2₁ bzw. 3₁ aufweist und an diesen Ausgängen 2₁ bzw. 3₁ zeitlich nacheinander eine bestimmte, dieser Steuereinrichtung 2 bzw. 3 zugeordnete und für eine Adressierung einer bestimmten Leitung 1₁, 1₂ ... bzw. 1_{N} maßgebende Binärinformation, beispielsweise jeweils die Information"1", erzeugt

Überdies sind erfindungsgemäß mehrere Verknüpfungselemente 4₁, 4₂, ... 4_{N} vorgesehen, deren jedes je einer bestimmten Leitung 1_{1,} 1₂ ... bzw. 1_{N} zugeordnet ist und einen dieser Leitung 1_{1,} 1₂ ... bzw. 1_{N} zugeordneten Ausgang 40₁, einen einer der beiden Steuereinrichtungen 2, 3, beispielsweise der Steuereinrichtung 2, zugeordneten Eingang 40₂ sowie einen der anderen Steuereinrichtung, im angenommenen Beispiel der Steuereinrichtung 3, zugeordneten Eingang 40₃ aufweist.

Jedes Verknüpfungselement 4₁, 4₂, ... bzw. 4_{N} adressiert die ihm allein zugeordnete bestimmte Leitung 1_{1,} 1₂ ... bzw. 1_{N} über seinen Ausgang 40₁ genau dann, wenn an seinem der einen Steuereinrichtung 2 zugeordneten Eingang 40₂ die dieser einen Steuereinrichtung 2 zugeordnete Binärinformation, im Beispiel die Information "1", und gleichzeitig an seinem der anderen Steuereinrichtung 3 zugeordneten Eingang 40₃ die dieser anderen Steuereinrichtung 3 zugeordnete Binärinformation, im Beispiel ebenfalls die Information "1", dieser anderen Steuerkette 3 anliegt.

Die Verknüpfungselemente 4₁ bis 4_{N} sind erfindungsgemäß in zueinander elementfremde und jeweils mehrere Verknüpfungselemente aufweisende Gruppen G₁, G₂, ... G_{q = 3} unterteilt, die zusammen sämtliche Verknüpfungselemente 4₁ bis 4_{N} ergeben.

Die der einen Steuereinrichtung 2 zugeordneten Eingänge 40₂ der Verknüpfungselemente 4₁, bis 4_{N} sind derart mit den Ausgängen 2₁ dieser Steuereinrichtung 2 verbunden, daß jeder dieser Ausgänge 2₁ mit nur einem dieser Eingänge 40₂ jeder Gruppe G₁, G₂, ... bzw. G_{q} verbunden ist.

Die der anderen Steuereinrichtung 3 zugeordneten Eingänge 40₃ der Verknüpfungselemente 4₁ bis 4_{N} sind derart gruppenweise mit den Ausgängen 3₁ dieser anderen Steuereinrichtung 3 verbunden, daß diese Eingänge 40₃ jeder Gruppe G₁, G₂, .... bzw. G_{q} gemeinsam mit einem dieser Gruppe G₁, G₂, ... G_{q} allein zugeordneten dieser Ausgänge 3₁ verbunden sind.

Sind generell N bestimmte Leitungen 1₁ bis 1_{N} vorgegeben und ist die Schrittweite p - 1 gewählt, wird zweckmäßigerweise so vorgegangen, daß die N Leitungen bzw. N Verknüpfungselemente in q = [N/p] Gruppen G₁ bis G_{q} unterteilt werden und danach eine andere Steuereinrichtung 3 mit q = [N/p] Ausgängen 3₁ gewählt wird. Dabei ist [N/p] = N/p, wenn N ohne Rest durch p teilbar ist, andernfalls ist (N/p] die nächsthöhere natürliche Zahl von N/p. Bei N = 8 und p = 3 ist beispielsweise N/p = 2 + 2/3 und demnach ist [N/p] gleich 3.

Die Unterteilung in Gruppen G₁ bis G_{q} wird überdies so vorgenommen, daß jede Gruppe G₁ bis G_{q}, ggf. bis auf eine, gleich viele Verknüpfungselemente aufweist, so wie im angenommenen Beispiel, bei dem von den q = 3 vorhandenen Gruppen G₁, G₂ und G₃ die Gruppe G₁ mit den Verknüpfungselementen 4₁, 4₂ und 4₃ und die Gruppe G₂ mit den Verknüpfungselementen 4₄, 4₅ und 4₆ jeweils drei und nur die dritte und letzte Gruppe G₃ mit den Verknüpfungselementen 4₇, 4₈ wegen der nicht ohne Rest durch 3 teilbaren Anzahl von N = 8 Leitungen nur zwei Verknüpfungselemente aufweist.

Es könnte anstelle der Steuereinrichtung 2 auch die Steuereinrichtung 3 als die eine Steuereinrichtung und anstelle der Steuereinrichtung 3 die Steuereinrichtung 2 als die andere Steuereinrichtung gewählt werden. In diesem Fall wäre jeder Ausgang 3₁ der Steuereinrichtung 3 mit den Verknüpfungselementen nur einer Gruppe G_{1,} G2, ... Gq und jeder Ausgang 2₁ der Steuereinrichtung 2 mit je einem Verknüpfungselement in jeder Gruppe G1, G2, ... bzw. Gq verbunden.

Jede Steuereinrichtung 2, 3 besteht vorzugsweise aus einer Steuerkette, bei der die dieser Steuereinrichtung 2 bzw. 3 zugeordnete Binärinformation, beispielsweise die Information "1", in einer bestimmten Richtung 21 bzw. 31 zeitlich nacheinander an den in dieser Richtung 21 bzw. 31 hintereinander angeordneten Ausgängen 2₁ bzw. 3₁ dieser Steuereinrichtung 2 bzw. 3 erscheint.

Die erfindungsgemäße beispielhafte Ausführungsform wird so betrieben, daß an den Ausgängen 2₁ der einen Steuereinrichtung 2 nacheinander die dieser Steuereinrichtung 2 zugeordnete bestimmte Binärinformation "1" erzeugt, an jedem dieser Ausgänge 2₁ diese erzeugte bestimmte Binärinformation "1" jeweils eine bestimmte Dauer T beibehalten, während dieser Dauer T an sämtlichen Ausgängen 3₁ der anderen Steuereinrichtung 3 nacheinander die dieser anderen Steuereinrichtung 3 zugeordnete bestimmte Binärinformation "1" erzeugt wird.

In dem beispielhaften Fall, daß beide Binärinformationen jeweils "1" sind, kann jedes Verknüpfungselement 4₁ bis 4_{N} ein UND-Glied sein, das durch einen einzelnen Transistor realisiert werden kann. Beispielsweise kann dieser Transistor ein MOS-Transistor sein, dessen Gate- und Drainanschluß die beiden Eingänge 40₂ und 40₃ bilden und dessen Source- bzw. Drainanschluß den Ausgang 40₁ dieses Verknüpfungselementes bildet.

Im allgemeinen Fall weist die eine Steuereinrichtung 2·p < N Ausgänge 2₁ und die andere Steuereinrichtung 3·q < N Ausgänge 3₁ auf. Durch p und q, die beides natürliche Zahlen sind, kann die Schrittweite weitgehend beliebig eingestellt werden. Im dargestellten Beispiel mit N = 8 ist die kleinste Schrittweite gewählt, die ein sprunghaftes Adressieren ermöglicht, d.h. die sprunghafte Adressierung springt von einer bestimmten Leitung zur übernächsten. Dies bedeutet, daß die Schrittweite gleich 3 ist. Entsprechend ist p, das für die Schrittweite maßgebend ist, gleich 3 gewählt. Da nur N = 8 Leitungen vorhanden sind, genügt q = 3.

In dem dargestellten Beispiel bewege sich der bestimmte Binärwert "1" in der einen Steuereinrichtung 2 vom untersten Ausgang 2₁ zum obersten Ausgang 2₁ und in der anderen Steuereinrichtung 3 bewege sich der zugeordnete bestimmte Binärwert "1" vom am weitesten links liegenden Ausgang 3₁ in Richtung 31 zum am weitesten rechts liegenden Ausgang 3₁.

Zu Beginn seien beide Steuereinrichtung 2 und 3 so eingestellt, daß ihre bestimmten Binärwerte "1" am untersten Ausgang 2₁ am weitesten links liegenden Ausgang 3₁ liegen. Dann ist zu Beginn die bestimmte Leitung 1₁ adressiert, da nur an dem mit dieser Leitung 1₁ verbunden Verknüpfungselement 4₁ die beiden Binärwerte "1" anliegen.

Mit dem nächsten Takt wird nur der Binärwert "1" der anderen Steuereinrichtung 3 in der Richtung 31 zum nächsten Ausgang 3₁ verschoben, in der einen Steuereinrichtung 2 bleibt dagegen der Binärwert "1" am untersten Ausgang 2₁. Jetzt ist die Leitung 1₄ ausgewählt, da nur an den Verknüpfungselementen 4₄ der Binärwert "1" zweimal anliegt.

Beim nächsten Takt bleibt weiterhin in der einen Steuereinrichtung 2 der Binärwert "1" am untersten Ausgang 2₁ und es wird nur der Binärwert "1" in der anderen Steuereinrichtung 3 in der Richtung 31 zum nächsten und letzten Ausgang 3₁ verschoben. Jetzt wird die Leitung 1₇ ausgewählt, da nur an dem Verknüpfungselement 4₇ der Binärwert "1" zweimal anliegt.

Beim nächsten Takt wird der Binärwert "1" in der anderen Steuereinrichtung 3 aus dieser Einrichtung 3 herausgeschoben und wieder zum am weitesten links liegenden Ausgang 3₁ dieser Einrichtung 3 gebracht. Gleichzeitig wird in der einen Steuereinrichtung 2 der Binärwert "1" in der Richtung 21 zum nächsten Ausgang 2₁ dieser Einrichtung 2 verschoben. Jetzt wird die Leitung 1₂ ausgewählt, da nur an dem Verknüpfungselement 4₂ der Binärwert "1" zweimal anliegt.

Bei den nächsten Takten bleibt wiederum in der einen Steuereinrichtung 2 der Binärwert "1" am nächsten Ausgang 2₁ und in der der anderen Steuereinrichtung 3 wird der Binärwert "1" sukzessive von Ausgang 3₁ zu Ausgang 3₁ verschoben. Es werden auf diese Weise nacheinander die Leitungen 1₅ und 1₈ adressiert.

Danach wird der Binärwert "1" in der anderen Steuereinrichtung 3 aus dieser Einrichtung 3 herausgeschoben und wieder an den am weitesten links liegenden Ausgang 3₁ dieser Einrichtung 3 gebracht, während der Binärwert "1" in der einen Steuereinrichtung 2 in der Richtung 21 zum obersten und letzten Ausgang 2₁ verschoben wird und dort verbleibt.

Während dieses Verbleibens des Binärwerts "1" am obersten Ausgang 2₁ der einen Steuereinrichtung 2 wird der Binärwert "1" in der anderen Steuereinrichtung 3 sukzessive in der Richtung 31 von Ausgang 3₁ zu Ausgang 3₁ verschoben. Es werden dadurch nacheinander die Leitungen 1₃ und 1₆ ausgewählt.

Da in diesem Fall an dem am weitesten rechts liegenden Ausgang 3₁ der anderen Steuereinrichtung 3 liegenden Binärwert "1" dieser Einrichtung 3 keine Leitung mehr zugeordnet ist, weil im Beispiel nur N = 8 und nicht 9 Leitungen vorhanden sind, ist es zweckmäßig, den am letzten Ausgang 3₁ anliegenden Binärwert "1" zu löschen und aus der anderen Steuereinrichtung 3 herauszuschieben und ebenso den am obersten Ausgang 2₁ anliegenden Binärwert "1" zu löschen und aus der einen Steuereinrichtung 2 herauszuschieben und danach den untersten Ausgang 2₁ der einen Steuerschaltung 2 und den am weitesten links liegenden Ausgang 3₁ der anderen Steuerschaltung 3 wieder jeweils mit dem Binärwert "1" zu besetzen, wonach der vorstehend beschriebene Vorgang von vorne abläuft.

Der Takt zum Verschieben des Binärwerts "1" der anderen Steuereinrichtung 3 von Ausgang 3₁ zu Ausgang 3₁ dieser Einrichtung 3 wird beispielsweise von einem Taktgeber 5 geliefert. Das Besetzen des am weitesten links liegenden Ausgang 3₁ der anderen Steuereinrichtung 3 und des untersten Ausgangs 2₁ der einen Steuereinrichtung 2, das Verschieben des Binärwerts "1" der einen Steuereinrichtung von Ausgang 2₁ zu Ausgang 2₁ und das Löschen des am weitesten rechts liegenden Ausgang 3₁ der anderen Steuereinrichtung 3 wird beispielsweise durch eine Steuerlogik 6 bewirkt.

Bei der erfindungsgemäßen Einrichtung ist vorteilhafterweise sowohl die Ansteuerung - es wird nur ein Takt benötigt - als auch der Aufbau - Steuerketten mit Logik - der sprungweisen Auswahl bei seriell arbeitenden Speichern mit Steuerketten wesentlich einfacher als mit Binärdekodierern.

## Patentansprüche

1. Einrichtung zum sprungweisen Adressieren bestimmter Leitungen (1₁ bis 1_{N}) eines seriell arbeitenden digitalen Speichers, bestehend aus:
- zwei den bestimmten Leitungen (1₁ bis 1_{N}) gemeinsam zugeordneten Steuereinrichtungen (2, 3), deren jede mehrere Ausgänge (2₁ bzw. 3₁) aufweist und an diesen Ausgängen (2₁ bzw. 3₁) zeitlich nacheinander eine bestimmte, dieser Steuereinrichtung (2 bzw. 3) zugeordnete und für eine Adressierung einer bestimmten Leitung (1₁, 1₂, ... oder 1_{N}) maßgebende Binärinformation ("1") erzeugt, und
- mehreren Verknüpfungselementen (4₁, 4₂, ... bzw. 4_{N}), deren jedes je einer bestimmten Leitung (1₁, 1₂, ... bzw. 1_{N}) zugeordnet ist und einen dieser Leitung (1₁, 1₂, ... bzw. 1_{N}) zugeordneten Ausgang (40₁), einen einer der beiden Steuereinrichtungen (2 oder 3) zugeordneten Eingang (40₂ bzw. 40₃) sowie einen der anderen Steuereinrichtung (3 bzw. 2) zugeordneten Eingang (40₃ bzw. 40₂) aufweist, wobei
- jedes Verknüpfungselement (4₁, 4₂, ... bzw. 4_{N}) die ihm allein zugeordnete bestimmte Leitung (1₁, 1₂, ... bzw. 1_{N}) über seinen Ausgang (40₁) genau dann adressiert, wenn an seinem der einen Steuereinrichtung (2 bzw. 3) zugeordneten Eingang (40₂ bzw. 40₃) die dieser Steuereinrichtung (2 bzw. 3) zugeordnete bestimmte Binärinformation ("1") und gleichzeitig an seinem der anderen Steuereinrichtung (3 bzw. 2) zugeordneten Eingang (40₃ bzw. 40₂) die dieser anderen Steuereinrichtung (3 bzw. 2) zugeordnete bestimmte Binärinformation ("1") anliegt, wobei
- die Verknüpfungselemente (4₁ bis 4_{N}) in zueinander elementfremde und jeweils mehrere Verknüpfungselemente aufweisende Gruppen (G₁, G₂, ... G_{q}) unterteilt sind, die zusammen sämtliche Verknüpfungselemente (4₁ bis 4_{N}) ergeben, wobei
- die einer (2 oder 3) der beiden Steuereinrichtungen (2, 3) zugeordneten Eingänge (40₂ bzw. 40₃) der Verknüpfungselemente (4₁ bis 4_{N}) derart mit den Ausgängen (2₁ bzw. 3₁) dieser Steuereinrichtung (2 bzw. 3) verbunden sind, daß jeder dieser Ausgänge (2₁ bzw. 3₁) mit nur einem dieser Eingänge (40₂ bzw. 40₃) jeder Gruppe (G₁, G₂, ... bzw. G_{q}) verbunden ist, und
- die der anderen Steuereinrichtung (3 bzw. 2) zugeordneten Eingänge (40₃ bzw. 40₂) der Verknüpfungselemente (4₁ bis 4_{N}) derart gruppenweise mit den Ausgängen (3₁ bzw. 2₁) dieser anderen Steuereinrichtung (3 bzw. 2) verbunden sind, daß diese Eingänge (40₃ bzw. 40₂) jeder Gruppe (G₁, G₂ ... bzw. G_{q}) gemeinsam mit einem dieser Gruppe (G₁, G₂, ... bzw. G_{q}) allein zugeordneten dieser Ausgänge (3₁ bzw. 2₁) verbunden sind.

2. Einrichtung nach Anspruch 1,
**dadurch gekennzeichnet,**
daß eine Steuereinrichtung (2, 3) aus einer Steuerkette besteht, bei der die zugeordnete Binärinformation ("1") in einer bestimmten Richtung (21, 31)) zeitlich nacheinander an den Ausgängen (2₁, 3₁) erscheint.

3. Verfahren zum Betrieb einer Anordnung nach Anspruch 1,
**dadurch gekennzeichnet,**
daß an den Ausgängen (2₁ bzw. 3₁) der einen Steuereinrichtung (2 bzw. 3) nacheinander die dieser Steuereinrichtung (2 bzw. 3) zugeordnete bestimmte Binärinformation ("1") erzeugt und an jedem dieser Ausgänge (2₁ bzw. 3₁) diese erzeugte bestimmte Binärinformation ("1") jeweils eine bestimmte Dauer (T) beibehalten und während dieser Dauer (T) an sämtlichen Ausgängen (3₁ bzw. 2₁) der anderen Steuereinrichtung (3 bzw. 2) nacheinander die dieser anderen Steuereinrichtung (3 bzw. 2) zugeordnete bestimmte Binärinformation ("1") erzeugt wird.

## Claims

1. Device for the jump-like addressing of specific lines (1₁ to 1_{N}) of a serially operating digital memory, comprising:
- two control devices (2, 3) which are jointly assigned to the specific lines (1₁ to 1_{N}), each of which control devices has a plurality of outputs (2₁ and 3₁) and, at these outputs (2₁ and 3₁), chronologically successively generates a specific binary information item ("1") assigned to this control device (2 or 3) and decisive for addressing a specific line (1₁, 1₂ ... 1_{N}, respectively), and
- a plurality of linking elements (4₁, 4₂, ... 4_{N}, respectively), each of which is assigned to a specific line (1₁, 1₂ ... 1_{N}, respectively) and has an output (40₁) assigned to this line (1₁, 1₂, ... 1_{N}, respectively), an input (40₂ or 40₃) assigned to one of the two control devices (2 or 3) as well as an input (40₃ or 40₂) assigned to the other control device (3 or 2, respectively),
- each linking element (4₁, 4₂, ... 4_{N}, respectively) addressing the specific line (1₁, 1₂, ... 1_{N}, respectively) assigned to it alone via its output (40₁) precisely when there is present at its intput (40₂ or 40₃) assigned to the one control device (2 or 3) the specific binary information item ("1") assigned to this control device (2 or 3) and, simultaneously, there is present at its input (40₃ or 40₂) assigned to the other control device (3 or 2) the specific binary information item ("1") assigned to this other control device (3 or 2),
- the linking elements (4₁ to 4_{N}) being subdivided into groups (G₁, G₂, ... G_{q}) which do not share the same elements and in each case have a plurality of linking elements, which groups together yield all the linking elements (4₁ to 4_{N}),
- the inputs (40₂ or 40₃), assigned to the one (2 or 3) of the two control devices (2, 3), of the linking elements (4₁ to 4_{N}) being connected to the outputs (2₁ or 3₁) of this control device (2 or 3) in such a way that each of these outputs (2₁ or 3₁) is connected to only one of these inputs (40₂ or 40₃) of each group (G₁, G₂, ... G_{q}, respectively) and
- the inputs (40₃ or 40₂), assigned to the other control device (3 or 2), of the linking elements (4₁ to 4_{N}) being connected in groups to the outputs (3₁ or 2₁) of this other control device (3 or 2) in such a way that these inputs (40₃ or 40₂) of each group (G₁, G₂, ... G_{q}, respectively) are jointly connected to one of these outputs (3₁ or 2₁) assigned to this group (G₁, G₂ ... G_{q}, respectively) alone.

2. Device according to Claim 1, characterized in that a control device (2, 3) comprises a control chain in which the associated binary information item ("1") appears chronologically successively in a specific direction (21, 31) at the outputs (2₁, 3₁).

3. Method for the operation of an arrangement according to Claim 1, characterized in that the specific binary information item ("1") assigned to the one control device (2 or 3) is generated successively at the outputs (2₁ or 3₁) of this control device (2 or 3) and, at each of these outputs (2₁ or 3₁), this generated specific binary information item ("1") is in each case maintained for a specific period (T), and during this period (T) the specific binary information item ("1") assigned to the other control device (3 or 2) is generated successively at all the outputs (3₁ or 2₁) of this other control device (3 or 2).

## Revendications

1. Dispositif permettant d'adresser par saut des lignes déterminées (1₁ à 1_{N}) d'une mémoire numérique à fonctionnement séquentiel, composé de :
- deux dispositifs de commande (2, 3) affectés ensemble aux lignes déterminées (1₁ à 1_{N}), dont chacun comporte plusieurs sorties (2₁ resp. 3₁) et génère à ces sorties (2₁ resp. 3₁), chronologiquement, une information binaire ("1") déterminée, affectée à ce dispositif de commande (2 resp. 3) et pertinente pour un adressage d'une ligne déterminée (1₁, 1₂, ... ou 1_{N}), et
- de plusieurs éléments logiques (4₁, 4₂, ... resp. 4_{N}) dont chacun est affecté à chaque fois à une ligne déterminée (1₁, 1₂, ... resp. 1_{N}) et comporte une sortie (40₁) affectée à cette ligne (1₁, 1₂, ... resp. 1_{N}), une entrée (40₂ resp. 40₃) affectée à un des deux dispositifs de commande (2 ou 3) ainsi qu'une entrée (40₃ resp. 40₂) affectée à l'autre dispositif de commande (3 resp. 2),
- chaque élément logique (4₁, 4₂, ... resp. 4_{N}) adressant via sa sortie (40₁) la ligne déterminée (1₁, 1₂, ... resp. 1_{N}) affectée à lui seul, précisément au moment où, simultanément, son entrée (40₂ resp. 40₃) affectée à l'un des dispositifs de commande (2 resp. 3) se voit appliquer l'information binaire ("1") déterminée affectée à ce dispositif de commande (2 resp. 3) et son entrée (40₃ resp. 40₂) affectée à l'autre dispositif de commande (3 resp. 2) se voit appliquer l'information binaire ("1") déterminée affectée à cet autre dispositif de commande (3 resp. 2),
- les éléments logiques (4₁ à 4_{N}) étant subdivisés en groupes (G₁, G₂, . .. G_{q}) constitués d'éléments étrangers l'un à l'autre et comportant à chaque fois plusieurs éléments logiques, qui forment ensemble la totalité des éléments logiques (4₁ à 4_{N}),
- les entrées (40₂ resp. 40₃) des éléments logiques (4₁ à 4_{N}), affectées à un (2 ou 3) des deux dispositifs de commande (2, 3), étant reliées aux sorties (2₁ resp. 3₁) de ce dispositif de commande (2 resp. 3) de telle façon que chacune de ces sorties (2₁ resp. 3₁) ne soit reliée qu'à une de ces entrées (40₂ resp. 40₃) de chaque groupe (G₁, G₂, ... resp. G_{q}), et
- les entrées (40₃ resp. 40₂) des éléments logiques (4₁ à 4_{N}), affectées à l'autre dispositif de commande (3 resp. 2), étant reliées par groupes aux sorties (3₁ resp. 2₁) de cet autre dispositif de commande (3 resp. 2) de telle façon que ces entrées (40₃ resp. 40₂) de chaque groupe (G₁, G₂, ... resp. G_{q}) soient reliées ensemble à une de ces sorties (3₁ resp. 2₁), affectée seule à ce groupe (G₁, G₂, ... resp. G_{q}).

2. Dispositif selon la revendication 1, caractérisé en ce qu'un dispositif de commande (2, 3) est composé d'une chaîne de commande, dans laquelle l'information binaire ("1") affectée apparaît chronologiquement aux sorties (2₁, 3₁), selon une direction (21, 31) déterminée.

3. Procédé permettant le fonctionnement d'un dispositif selon la revendication 1, caractérisé en ce qu'on génère aux sorties (2₁ resp. 3₁) de l'un des dispositifs de commande (2 resp. 3), successivement, l'information binaire ("1") déterminée affectée à ce dispositif de commande (2 resp. 3), on maintient cette information binaire ("1") déterminée générée, à chacune de ces sorties (2₁ resp. 3₁), à chaque fois pendant une durée (T) déterminée et on génère pendant cette durée (T), à toutes les sorties (3₁ resp. 2₁) de l'autre dispositif de commande (3 resp. 2), successivement, l'information binaire ("1") déterminée affectée à cet autre dispositif de commande (3 resp. 2).
